Europäisches Patentamt

European Patent Office

Office européen des brevets

(11) Publication number: **0 188 919**
**B1**

(12) **EUROPEAN PATENT SPECIFICATION**

(45) Date of publication of patent specification: **31.05.89**

(21) Application number: **85309444.9**

(22) Date of filing: **23.12.85**

(51) Int. Cl.⁴: **G 02 B 5/18,** G 02 B 5/32,
H 01 S 3/06, G 02 B 27/44

(54) **A method for the formation of a diffraction grating.**

(30) Priority: **27.12.84 JP 278999/84**

(43) Date of publication of application:
**30.07.86 Bulletin 86/31**

(45) Publication of the grant of the patent:
**31.05.89 Bulletin 89/22**

(84) Designated Contracting States:
**DE GB NL**

(56) References cited:
**DE-A-1 094 484**
**US-A-4 402 571**

**ELECTRONICS LETTERS, vol. 20, no. 24, 22nd
November 1984, pages 1008-1010, Stevenage,
Herts, GB; K. UTAKA et al.: "Lambda/4-shifted
InGaAsP/InP DFB lasers by simultaneous
holographic exposure of positive and negative
photoresists"**

**JAPANESE JOURNAL OF APPLIED PHYSICS,
vol. 23, no. 10, part 2, October 1984, pages
L791-L794, Tokyo, JP; S. KOENTJORO et al.:
"Active distributed reflector lasers phase
adjusted by groove region"**

(73) Proprietor: **SHARP KABUSHIKI KAISHA
22-22 Nagaike-cho Abeno-ku
Osaka 545 (JP)**

(72) Inventor: **Yoshida, Toshihiko
2613-1, Ichinomoto-cho
Tenri-shi Nara-ken (JP)**
Inventor: **Takiguchi, Harushisa
4-8-18, Noe
Joto-ku Osaka (JP)**
Inventor: **Kaneiwa, Shinji
101 Kyobate Mansion 182-2 1-chome
Minamikyobate-cho Nara-shi Nara-ken (JP)**
Inventor: **Matsui, Sadayoshi
289-53, Nishinagara-cho
Tenri-shi Nara-ken (JP)**

(74) Representative: **Billington, Lawrence Emlyn
et al
HASELTINE LAKE & CO Hazlitt House 28
Southampton Buildings Chancery Lane
London WC2A 1AT (GB)**

Courier Press, Leamington Spa, England.

(56) References cited:
**PROCEEDINGS OF THE SOCIETY OF PHOTO-OPTICAL INSTRUMENTATION ENGINEERS, vol. 239, Spie, Guided wave optical and surface acoustic wave devices. Systems and applications, 1980, pages 10-18; A. SUZUKI et al.: "Theory and experiment on distributed feedback lasers with chirped grating" SPIE, Vol. 239 (1980) p.10-18;**

## Description

This invention relates to a method for the formation of diffraction gratings.

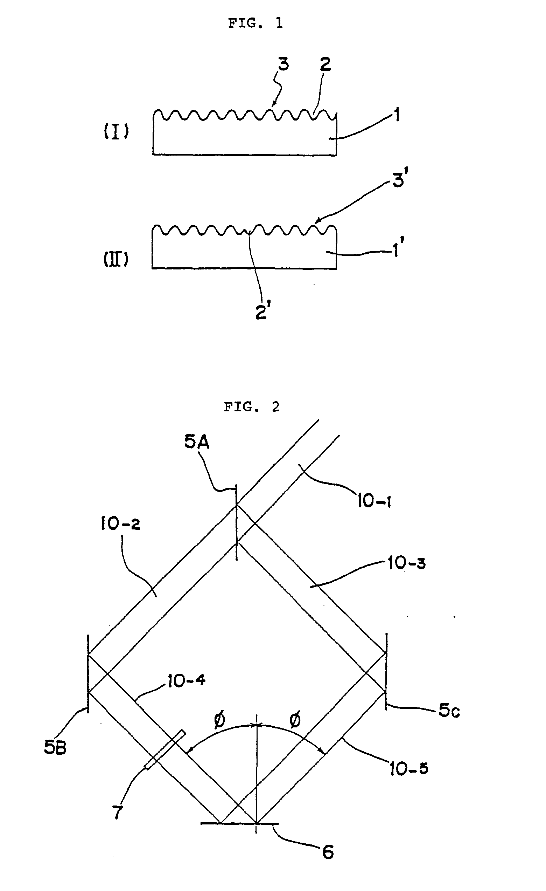

A diffraction grating with a periodicity is formed on the surface of a semiconductor crystal, for use as a reflecting surface of a distributed-feedback (DFB) laser. This distributed-feedback laser is advantageous over other lasers in that cleavage of the crystal is not required for the formation of the resonator, integration can be readily attained, and stabilized single-mode operation can be readily provided. However, as shown in Figure 1(I), with a distributed-feedback laser in which the diffraction grating 3 is composed of grooves 2 with a periodicity on the upper surface of substrate 1, stabilized oscillation in a single mode cannot be achieved. In particular, it is not possible to obtain single-mode operation when high-speed modulation is involved, as when the laser is being used as a light source for optical communication apparatus. In order to solve this problem, a distributed-feedback semiconductor laser such as that shown in Figure 1(II) has been proposed in recent years in which the grooves 2' of the diffraction grating 3' in the region of the center of the resonator are shifted by half a cycle (namely, the phase of the pattern of the diffraction grating is shifted by $\pi$).

The phase shift of the diffraction grating in the middle of the laser resonator is achieved as follows:

a photoresist is coated on a semiconductor substrate and exposed by an electronic beam-exposing system and then developed to form the portions corresponding to the grooves of the diffraction grating. The substrate is then etched with an etchant.

The remaining photoresist on the substrate functions as an etching mask. However, while the phase of the diffraction grating can be changed at will, to construct even one semiconductor laser is extremely time-consuming; productivity is low, costs are high, and thus the method is not practical. Alternatively, a positive photoresist, in which areas which have been exposed to light are removed by a development process, is coated on the right half of the laser resonator, and a negative photoresist, in which areas which have not been exposed to light are removed by a development process, is coated on the left half of the resonator. Then, both the photoresists are exposed by a holographic exposing system and developed, and the remaining photoresist is used as a mask in the succeeding etching process. However, the efficiency of the negative resist is poor, and the application of the resist is difficult. Moreover, the phase shift is limited to only $\pi$.

US—A—4 402 571 discloses a laser-target arrangement for exposure of a photoresist, in which one of two light beams obtained from a beam-splitter passes through a phase shifter.

An article in SPIE, Vol.239, p10—18 by Suzuki et al, entitled "Theory and experiment on distributed feedback lasers with chirped grating", discloses optically pumped GaAs DFB lasers with a variable grating period fabricated by holographic interference. The recording arrangement and geometry for forming the grating by holographic interference is shown in Figure 6 of that document: it uses pinholes rather than lenses or mirrors, the pinholes providing spatial filtering of higher spatial Fourier components of the incident laser beams. This arrangement produces a uniform profile of corrugation in the resulting grating.

According to the present invention, there is provided a method for the manufacture of a diffraction grating to be formed on a substrate and provided with a change in phase of the grating pattern at a specific location in the pattern, using a holographic technique and an etching technique, characterised in that said change in phase of the grating pattern is effected by introducing a difference in light path length between one portion and the remaining portion of one light beam of two light beams of a holographic exposing system.

The change of the light-path length is, in a preferred example of the method, achieved by passing said one light beam through a transparent plate (phase plate), namely a plate having a stepped cross-section defining a thicker portion and a thinner portion.

The difference $\triangle d$ in thickness between the thicker portion and the thinner portion of said transparent plate has, in a preferred example, the following relationship to the wavelength of the light passing through said transparent plate:

$$n \cdot \triangle d = \lambda/4$$

The width (extent) of the thicker portion of said transparent plate is, in a preferred example, equal to that of the thinner portion.

The width of both the thicker portion and the thinner portion of said transparent plate is, in a preferred example, equal to the length of a semiconductor laser resonator which is obtained using the substrate having said diffraction grating thereon.

An example of the present invention may allow the formation of diffraction gratings with a periodicity of approximately 2000 Å on the surface of a semiconductor substrate, in which the phase of the diffraction gratings can be changed at will.

Thus, the invention described herein addresses the problems of (1) providing a simple method for the formation of a diffraction grating, the phase of which is changed by $\pi$ in the middle of a semiconductor laser resonator; (2) providing a method for the formation of a diffraction grating which is applied to produce a distributed-feedback semiconductor laser device having a diffraction grating the phase of which is changed by $\pi$ in the middle of the semiconductor laser resonator, said laser device oscillating in a stabilized single mode even when high-speed modulation is involved as when the laser device is used in a light source for optical communication; and (3) providing a method for the formation of a diffraction grating which can be applied to produce a distributed Bragg reflection semiconductor laser device.

Reference is made, by way of example, to the accompanying drawings in which:

Figure 1(I) is a front view of a substrate having a diffraction grating thereon with a uniform phase;

Figure 1(II) is a front view of a substrate having a diffraction grating thereon, exhibiting an altered phase pattern in the center portion of the substrate;

Figure 2 is a diagram showing a holographic exposing system used in this invention;

Figure 3 is a sectional front view showing the transparent plate shown in Figure 2;

Figure 4 is a plan view showing interference fringes formed on a photoresist which is coated on the substrate; and

Figure 5(I),II and (II), respectively, are diagrams showing stages in the production of a diffraction grating, exhibiting an altered phase pattern in the center portion of the substrate, according to this invention.

An example of this invention provides a method for the formation of a diffraction grating in which by passing one of the two light beams from a holographic exposing system through a transparent plate of uneven thickness (phase plate) a change of the light-path length is achieved at will, thereby attaining a change in phase in the pattern of the diffraction grating.

Figure 2 shows a holographic exposing system to which the present invention may be applied, comprising a beam splitter 5A and a pair of plane mirrors 5B and 5C. In the light path from the plane mirror 5B to a substrate 6 on which the diffraction grating is formed, a transparent plate 7 is disposed.

A light beam 10—1 which is coherent and collimated, e.g., He—Cd laser light with a wavelength of 441.6 nm, is incident upon the beam splitter 5A of the above-mentioned holographic exposing system to be split into two light beams 10—2 and 10—3 having the same optical intensity, which are then incident upon the plane mirrors 5B and 5C, respectively. The reflected light beams 10—4 and 10—5 from the mirrors 5B and 5C, respectively, are superposed on a photoresist coated on the substrate 6 resulting in interference fringes. Since the reflected light beam 10—4 from the mirror 5B reaches the photoresist on the substrate 6 through the transparent plate 7, the light-path length of the light beam 10—4 is different from that of the other light beam 10—5 reflected from the mirror 5C.

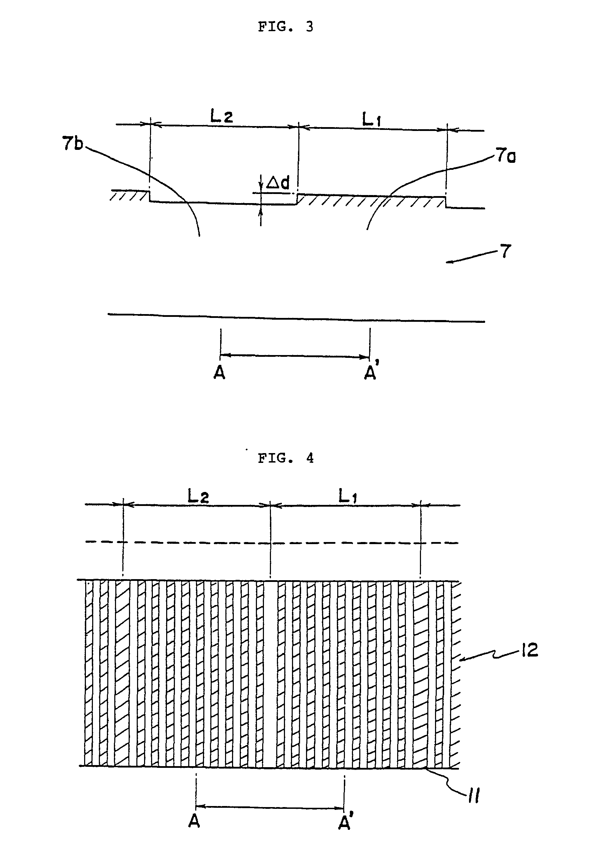

Figure 3 shows that the transparent plate 7 is of uneven (stepped) thickness, the width $L_1$ of the thicker portion 7a being equal to the width $L_2$ of the thinner portion 7b, and $L_1 + L_2$ corresponding to the length L of the finally obtainable semiconductor laser resonator. Moreover, the difference $\triangle S$ between the light-path length of the light passing through the thicker portion 7a and that of the light passing through the thinner portion 7b is one-quarter of the wavelength $\lambda$ of the laser light, as represented by the equation:

$$\triangle S = n. \triangle d = \lambda/4$$

where n is a refractive index of the plate material, and $\triangle d$ is the difference in thickness between the thicker portion 7a and the thinner portion 7b.

The transparent plate (or phase plate) 7 can be produced by subjecting silicon oxide film, vaporized (vapour-deposited) on a plane plate made of fused quartz, to a photolithographic treatment.

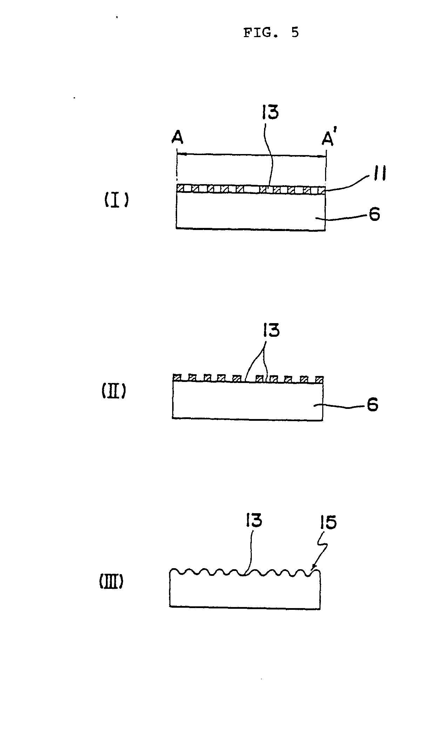

By use of the transparent plate 7 having the above-mentioned structure, interference fringes 12 composed of light and dark areas with an inversion in the center of the middle region A—A' of the substrate 6 are formed on the photoresist 11 coated on the substrate 6 as shown in Figures 4 and 5(I), (the nonhatched areas in Figure 4 indicate the exposed areas). The photoresist 11 is then developed, and as shown in Figure 5(II), the exposed areas are eliminated, resulting in grooves 13 parallel to each other. The substrate 6 is then etched with an etchant ($HBr:HNO_3:CH_3OH = 1:1:5$). The remaining photoresist serves as an etching mask. The mask is then removed, resulting in a diffraction grating 15 on the substrate 6, in which the phase of the groove pattern is shifted by $\pi$ in the center 16 of the obtained semiconductor laser resonator.

Although the above-mentioned example describes only the method for the formation of a diffraction grating the phase of which is changed by $\pi$ in the center of a semiconductor laser resonator, it is not limited thereto. By modification of the difference $\triangle d$ in thickness between the thicker portion and the thinner portion of the transparent board and/or by varying the widths $L_1$ and $L_2$, diffraction gratings with different changes in phase at specific locations can be produced.

**Claims**

1. A method for the manufacture of a diffraction grating (15) to be formed on a substrate (6) and provided with a change in phase of the grating pattern at a specific location in the pattern, using a holographic technique and an etching technique, characterised in that said change in phase of the grating pattern is effected by introducing a difference in light path length between one portion and the remaining portion of one light beam (10—4) of two light beams (10—4, 10—5) of a holographic exposing system (5A, 5B, 5C).

2. A method according to claim 1, wherein the difference in the light-path length between said one portion and said remaining portion of said one light beam (10—4) is achieved by passing said one light beam (10—4) through a transparent plate (7) having a stepped cross-section thereby defining a thicker portion (7a) and a thinner portion (7b) of said plate.

3. A method according to claim 2, wherein the difference $\triangle d$ in thickness between the thicker portion (7a) and the thinner portion (7b) of said transparent plate (7) has the following relationship to the wavelength of the light (λ) passing through said transparent plate (7):

$$n \cdot \triangle d = \lambda/4$$

4. A method according to claim 2 or 3, wherein the width (L$_1$) of the thicker portion (7a) of said transparent plate (7) is equal to the width (L$_2$) of the thinner portion (7b) of said transparent plate (7).

5. A method according to claim 4, wherein the width of both the thicker portion (7a) and the thinner portion (7b) of said transparent plate (7) is equal to the length of a semiconductor laser resonator which is obtained using the substrate (6) having said diffraction grating (15) thereon.

6. A method for the manufacture of a diffraction grating as claimed in any preceding claim, wherein:
(a) the substrate (6) is covered by a photoresist (11);
(b) the two light beams of the holographic exposing system are obliquely directed from different sides onto the substrate (6) to interfere in the photoresist (11);
(c) after exposure of the photoresist (11) by the light beams, the photoresist (11) is developed;
(d) after developing the photoresist (11), the substrate (6) is etched using the developed photoresist (11) as an etching mask; and
(e) the etching mask is removed, leaving the diffraction grating (15) provided with a change in phase of the grating pattern along a line corresponding to the interface between said one portion and said remaining portion of said one light beam (10—4).

**Patentansprüche**

1. Verfahren zur Herstellung eines Beugungsgitters (15) auf einem Substrat (6) und das an einer bestimmten Stelle in der Gitterstruktur mit einer Phasenveränderung versehen ist, unter Verwendung einer Holographie-Technik und einer Ätz-Technik, daduch gekennzeichnet, daß die Phasenveränderung der Gitterstruktur dadurch bewirkt wird, indem eine Differenz in der Lichtweglänge zwischen einem Teil und dem übrigen Teil eines Lichtstrahls (10—4) von zwei Lichtstrahlen (10—4, 10—5) eines holographischen Belichtungssystems (5A, 5B, 5C) eingeführt wird.

2. Verfahren nach Anspruch 1, bei dem die Differenz in der Lichtweglänge zwischen dem einen Teil und dem übrigen Teil dieses einen Lichtstrahls (10—4) erreicht wird, indem dieser eine Lichtstrahl (10—4) durch eine transparente Platte (7) geleitet wird, die einen abgestuften Querschnitt hat, wodurch ein dickerer Abschnitt (7a) und ein dünnerer Abschnitt (7b) der Platte gebildet wird.

3. Verfahren nach Anspruch 2, bei dem die Differenz △d in der Dicke zwischen dem dickeren Abschnitt (7a) und dem dünneren Abschnitt (7b) der transparenten Platte (7) die folgende Beziehung zur Wellenlänge des Lichtes (λ) hat, das durch die transparente Platte (7) tritt:

$$n \cdot \triangle d = \lambda/4$$

4. Verfahren nach Anspruch 2 oder 3, bei dem die Breite (L$_1$) des dickeren Abschnitts (7a) der transparenten Platte (7) gleich der Breite (L$_2$) des dünneren Abschnitts (7b) der transparenten Platte (7) ist.

5. Verfahren nach Anspruch 4, wobei die Breite von sowohl dem dickeren Abschnitt (7a) als auch dem dünneren Abschnitt (7b) der transparenten Platte (7) gleich der Länge eines Halbleiter-Laserresonators ist, der durch Verwendung des Substrats (6) mit dem darauf befindlichen Beugungsgitter (15) erhalten wird.

6. Verfahren zur Herstellung eines Beugungsgitters nach einem der vorhergehenden Ansprüche, wobei:
(a) das Substrat (6) durch einen Photoresist (11) abgedeckt wird;
(b) die zwei Lichtstrahlen des holographischen Belichtungssystems von verschiedenen Seiten schräg auf das Substrat (6) gerichtet werden, um in dem Photoresist (11) zu interferieren;
(c) nach dem Belichten des Photoresists (11) durch die Lichtstrahlen der Photoresist (11) entwickelt wird;
(d) nach dem Entwickeln des Photoresistes (11) das Substrat (6) unter Verwendung des entwickelten Photoresists (11) als Ätzmaske geätzt wird; und
(e) die Ätzmaske entfernt wird, wodurch das Beugungsgitter (5) mit einer Phasenänderung in der Gitterstruktur entlang einer Linie zurückgelassen wird, die der Schnittstelle zwischen dem einen Teil und dem übrigen Teil des einen Lichtstrahls (10-4) entspricht.

**Revendications**

1. Un procédé pour la fabrication d'un réseau de diffraction (15) devant être formé sur un substrat (6) et réalisé avec une modification de phase du motif de réseau en un emplacement particulier du motif, en utilisant une technique holographique et une technique de gravure, caractérisé en ce que ladite phase du motif de réseau est effectuée en introduisant une différence dans la longueur du parcours lumineux entre une partie et la partie restante d'un faiscéau lumineux (10—4) de deux faisceaux lumineux (10—4, 10—5) d'un système d'exposition holographique (5A, 5B, 5C).

2. Un procédé selon la revendication 1, dans lequel la différence dans la longueur du parcours de la lumière entre ladite partie et ladite partie restante dudit faisceau lumineux (10—4) est réalisée en faisant passer ledit faisceau lumineux (10—4) à travers une plaque transparente (7) ayant une coupe transversale étagée, permettant ainsi de définir une partie plus épaisse (7a) et une partie plus fine (7b) de ladite plaque.

3. Un procédé selon la revendication 2, dans lequel la différence $\triangle d$ en épaisseur, entre la partie plus épaisse (7a) et la partie plus fine (7b) de ladite plaque transparente (7), a la relation suivante à la longueur d'onde de la lumière ($\lambda$) passant à travers ladite plaque transparente (7):

$$n \cdot \triangle d = \lambda/4$$

4. Un procédé selon la revendication 2 ou 3, dans lequel la largeur ($L_1$) de la partie la plus épaisse (7a) de ladite plaque transparente (7) est égale à la largeur ($L_2$) de la partie la plus fine (7b) de ladite plaque transparente (7).

5. Un procédé selon la revendication 4, dans lequel la largeur de, à la fois, la partié la plus épaisse (7a) et la partie la plus fine (7b) de ladite plaque transparente (7), est égale à la longueur d'un résonateur laser à semi-conducteur qui est obtenu en utilisant le substrat (6) ayant ledit réseau de diffraction (15) sur sa surface.

6. Un procédé pour la fabrication d'un réseau de diffraction comme revendiqué dans l'une quelconque des revendications précédentes, dans lequel:

(a) un substrat (6) est recouvert d'un photorésist (11);

(b) les deux faisceaux lumineux du système d'exposition holographique sont dirigés obliquement depuis différents côtés sur le substrat (6) pour interférer dans le photorésist (11);

(c) après exposition du photorésist (11) par les faisceaux lumineux, le photorésist (11) est développé;

(d) après développement du photorésist (11), le substrat (6) est gravé en utilisant le photorésist (11) développé comme un masque de gravure, et

(e) le masque de gravure est éliminé, laissant le réseau de diffraction (15) fourni avec une modification de phase du motif de réseau suivant une ligne correspondant à l'interface entre ladite partie et ladite partie restante dudit faisceau lumineux (10—4).

FIG. 1

FIG. 2

FIG. 3

FIG. 4

FIG. 5

(I)

13

A            A'

11

6

(II)

13

6

(III)

13     15